# EUROPÄISCHE PATENTSCHRIFT

(11) **EP 3 637 157 B1**
(45) Veröffentlichungstag und Bekanntmachung des Hinweises auf die Patenterteilung: **28.12.2022**
(21) Anmeldenummer: 19186204.4
(22) Anmeldetag: 15.07.2019
(51) Int. Cl.: G03F 1/78, G02B 5/18

(54) **GITTERSTRUKTUR FÜR EINE DIFFRAKTIVE OPTIK**
GRATING STRUCTURE FOR DIFFRACTIVE OPTICS
STRUCTURE DE GRILLE POUR UNE OPTIQUE DIFFÉRENTIELLE

(30) Priorität: 09.10.2018 DE 102018217199
(43) Veröffentlichungstag der Anmeldung: 15.04.2020
(73) Patentinhaber: Dr. Johannes Heidenhain GmbH, 83301 Traunreut (DE)
(72) Erfinder: WEIDMANN, Josef, 84550 Feichten a.d. Alz (DE); SPECKBACHER, Peter, 84558 Kirchweidach (DE)

(56) Entgegenhaltungen:
- EP-A1- 3 321 641
- US-A1- 2011 278 731
- US-A1- 2013 283 216

## Beschreibung

### GEBIET DER TECHNIK

Die vorliegende Erfindung betrifft eine Gitterstruktur für eine diffraktive Optik.

### STAND DER TECHNIK

Im Stand der Technik sind Gitterstrukturen mit periodisch angeordneten Gitterlinien bekannt. Insbesondere bilden solche Gitterstrukturen Beugungsgitter für die Transmission oder Reflexion von Licht mit unterschiedlichen phasenschiebenden Wirkungen.

Feine planare Gitterstrukturen, wie beispielsweise optische Elemente für diffraktive optische Elemente oder Beugungsgitter oder Wellenleiter, werden üblicherweise durch lithographische Direktschreibverfahren erzeugt. Für Strukturbreiten, d.h. die Breiten der strichförmigen Gitterlinien der entsprechenden Gitterstrukturen, von nur wenigen 100 nm verwendet man hierzu üblicherweise Elektronenstrahlgeräte. Die mit Hilfe solcher Elektronenstrahlgeräte erzeugten Elektronenstrahlen können auf Punkte bis zu Nanometern Durchmesser fokussiert werden.

Da jedoch mit so geringen Strahlflächen sehr hohe Belichtungszeiten für größere Flächen der Struktur entstehen, eignen sich Punktstrahlgeräte (sogenannte Gaußtrahlschreiber) nur zur Erzeugung relativ kleiner Strukturflächen. Benötigt man größere Strukturflächen, so muss man auf die deutlich aufwendigere Formatstrahltechnologie übergehen (variable shaped beam, VSB). In der VSB-Technologie wird ein flächiger Elektronenstrahl genutzt. Der Elektronenstrahl wird in der Elektronenquelle erzeugt und durch eine Strahlblende üblicherweise zu einem runden Strahlquerschnitt geformt. Die maximal nutzbare Fläche ist durch die radiale Homogenität der Stromdichte begrenzt. Typischerweise wird eine Homogenität von wenigen Prozent angestrebt, wodurch sich ein Maximaldurchmesser Dₘₐₓ ergibt. Der Wert für Dₘₐₓ liegt typischerweise in einem Bereich von 1 - 20 µm. Aus der entsprechenden Kreisfläche werden in der VSB-Technologie durch eine Überlagerung von zwei quadratischen Blenden mit Hilfe einer elektrischen und/oder magnetischen Ablenkung beliebige Rechtecke (sogenannte variable Manhattan-Rechtecke) bis zur Größe eines Maximalquadrats ausgeschnitten. Die variablen Manhattan-Rechtecke werden auch als Stempel oder "Shapes" bezeichnet. Diese Stempel bzw. Shapes werden gepulst (Pulsdauer typischerweise im Bereich von wenigen Mikrosekunden) erzeugt und unter Verwendung weiterer elektrischer und/oder magnetischer Ablenksysteme auf eine zu belichtende Substratoberfläche gesetzt. Zusätzlich wird die Substratoberfläche mit Hilfe eines XY-Verfahrtisches bewegt.

Die VSB-Technologie eignet sich insbesondere dazu, rechtwinklige Strukturen, d.h. Strukturen mit Kanten parallel zur x- und y-Achse eines Referenzkoordinatensystems bzw. des XY-Verfahrtisches, zu belichten (sogenannte Manhattan-Strukturen). Hierbei sind gegenüber Punktstrahlgeräten deutliche Geschwindigkeitsvorteile in Bezug auf die Belichtungszeit erzielbar. Bei nichtrechtwinkligen, d.h. nicht orthogonalen Strukturen, reduziert sich der Geschwindigkeitsvorteil jedoch wieder, weil schräge Linien durch sehr feine Treppenapproximationen erzeugt werden müssen, was die Verwendung einer Vielzahl von kleinen rechtwinkligen Stempeln bzw. Shapes bedeutet.

Wenn die Struktur schließlich nur aus schmalen, nicht orthogonalen Strukturen besteht, also keine größeren Einzelflächen existieren, was bei feinen planaren Gitterstrukturen der Fall ist, verschwindet der vorgenannte Vorteil der VSB-Technologie nahezu vollständig. In diesem Fall erhöhen sich die Anzahl der Stempel und somit die Belichtungszeit signifikant. Andererseits führt eine Erhöhung des Approximationslimits zur Reduzierung der Stempelanzahl zu einer entsprechenden Erhöhung der Kantenrauheit (line edge roughness, LER). Ferner hat die VSB-Technologie den Nachteil, dass die Approximation bei sehr schrägen Linien, d.h. bei Winkeln, die weit entfernt sind von im Referenzkoordinatensystem definierten Winkeln von 0° bzw. 90°, durch ein Verschmelzen benachbarter Strukturen schnell limitiert ist. Insgesamt bleiben in der VSB-Technologie, insbesondere bei der Approximation von schrägen bzw. gekrümmten Linien der Struktur, die Anzahl der Stempel und somit die Belichtungszeit bei Belichtung größerer Flächen aus technischer und wirtschaftlicher Sicht zu hoch.

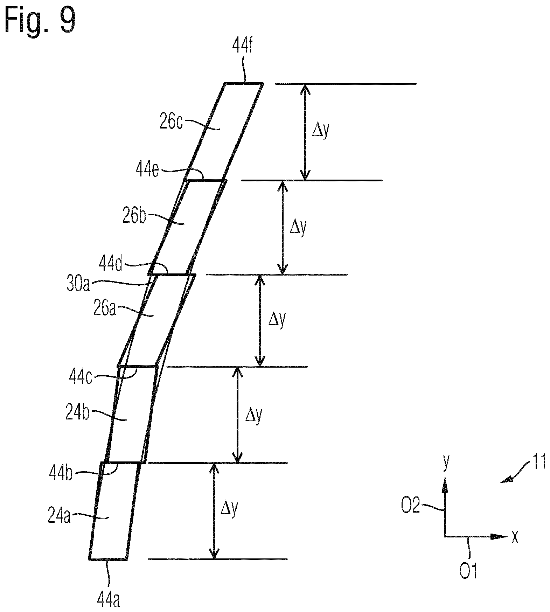

US 8,865,377 B2 offenbart ein Verfahren und ein System zur Erzeugung eines diagonalen Musters unter Verwendung der VSB-Technologie. Das in Bezug auf Fig. 9B gezeigte diagonale Muster umfasst mehrere aufeinanderfolgende Segmentabschnitte zur Approximation eines Bereichs eines Siliziumwafers, wobei Längsachsen jeweils benachbarter Segmentabschnitte verschiedene Winkel relativ zu einer ersten Koordinatenachse eines Referenzkoordinatensystems haben.

Die im Stand der Technik bekannten Verfahren zur Approximation der Gitterlinien einer Gitterstruktur sind insbesondere dahingehend nachteilhaft, dass wenn die Einstellung der Winkel der Längsachsen der Segmente an jeder Position der Gitterlinien der Gitterstruktur in Abhängigkeit einer zu erzielenden minimalen Kantenrauheit erfolgt, es an einem Grenzpunkt zwischen zwei benachbarten Segmenten, deren Längsachsen verschiedene Winkel haben, zu einer abrupten Winkel- bzw. Richtungsänderung kommt, die für alle Gitterlinien der Gitterstruktur in etwa an der gleichen Position (bzw. am gleichen Tangentenwinkel, d.h. Winkel der Tangente der jeweiligen Gitterlinie) stattfindet. Dadurch kommt es makroskopisch wiederum zur Bildung unterschiedlicher Abschnitte bzw. Zonen, die jeweils eines der beiden benachbarten Segmente umfassen. An den Abschnitts- bzw. Zonengrenzen erfolgt dann eine sprunghafte Veränderung der Lichtbeugung, da der mikroskopische Effekt der Lichtbeugung an einem einzelnen Grenzpunkt durch eine Aufsummierung über die Vielzahl von Segmenten aller Gitterlinien verstärkt wird.

US 2013/283216 A1 offenbart ein Verfahren zur Maskendatenaufbereitung oder Maskenprozesskorrektur, bei dem ein Satz geladener Teilchenstrahlschüsse bestimmt wird, der in der Lage ist, ein Muster auf einer Oberfläche zu bilden, wobei die "critical dimension uniformity" (CDU) des Musters optimiert wird. In einigen Ausführungsformen wird die CDU durch Variieren von mindestens zwei Faktoren optimiert. In anderen Ausführungsformen werden modellbasierte Techniken verwendet. In noch anderen Ausführungsformen ist die Oberfläche ein Retikel, das in einem optischen Lithographieprozess verwendet werden soll, um ein Muster auf einem Wafer zu bilden, und die CDU auf dem Wafer ist optimiert.

EP 3 321 641 A1 offenbart eine Gitterstruktur für eine diffraktive Optik nach dem Oberbegriff des Anspruchs 1.

US 2011/278731 A1 offenbart ein Verfahren zum Entwurf und zur Herstellung einer integrierten Schaltung unter Verwendung diagonaler Muster minimaler Breite.

Der vorliegenden Erfindung liegt die Aufgabe zugrunde, eine Gitterstruktur für eine diffraktive Optik zu schaffen, die qualitativ hochwertig ist und deren Gitterlinien durch Segmente nahezu optimal approximiert sind.

Diese Aufgabe wird erfindungsgemäß durch eine Gitterstruktur für eine diffraktive Optik mit den Merkmalen des Anspruchs 1 gelöst.

Die erfindungsgemäße Gitterstruktur für eine diffraktive Optik umfasst mehrere Gitterlinien, wobei jede Gitterlinie durch mehrere aufeinanderfolgende Segmente approximiert ist. Längsachsen der Segmente haben jeweils einen Winkel relativ zu einer ersten Koordinatenachse eines Referenzkoordinatensystems. Ein erster Abschnitt einer Gitterlinie ist durch eine erste Gruppe von Segmenten approximiert, und ein an den ersten Abschnitt angrenzender zweiter Abschnitt der Gitterlinie ist durch eine zweite Gruppe von Segmenten approximiert. Die Längsachsen eines Hauptanteils der Segmente der ersten Gruppe haben einen ersten vorbestimmten Winkel relativ zur ersten Koordinatenachse des Referenzkoordinatensystems, und die Längsachsen eines Hauptanteils der Segmente der zweiten Gruppe haben einen von dem ersten vorbestimmten Winkel verschiedenen zweiten vorbestimmten Winkel relativ zur ersten Koordinatenachse des Referenzkoordinatensystems. Durch die unterschiedliche, jeweils vorbestimmte Ausrichtung der Hauptanteile der Segmente der ersten und zweiten Gruppe kann eine nahezu optimale Approximation der Gitterlinien, insbesondere von schrägen (geraden) oder teilweise gekrümmten Linien der Gitterstruktur, erreicht bzw. beibehalten werden.

Unter dem oben genannten Hauptanteil wird insbesondere verstanden, dass die Längsachsen der meisten oder aller Segmente der ersten bzw. zweiten Gruppe den jeweiligen vorbestimmten Winkel haben.

Einer oder mehrere der Winkel der Längsachsen der Segmente der ersten Gruppe und/oder einer oder mehrere der Winkel der Längsachsen der Segmente der zweiten Gruppe sind jeweils zufällig aus der Gesamtheit zumindest des ersten vorbestimmten Winkels und des zweiten vorbestimmten Winkels ausgewählt. Durch die vorgenannte stochastische Verschmierung der Ausrichtungen der Segmente der ersten und zweiten Gruppe kann eine sprunghafte Veränderung der Lichtbeugung als ein aufgrund einer abrupten Winkel-bzw. Richtungsänderung jeweils an Grenzpunkten zwischen zwei benachbarten Segmenten der Gitterlinien auftretender makroskopischer Effekt vermieden werden.

Vorzugsweise entsprechen die zufällig ausgewählten Winkel der Längsachsen der Segmente der ersten und/oder zweiten Gruppe jeweils mit einer ersten Wahrscheinlichkeit dem ersten vorbestimmten Winkel und mit einer zweiten Wahrscheinlichkeit dem zweiten vorbestimmten Winkel.

Vorzugsweise hängen die erste Wahrscheinlichkeit und die zweite Wahrscheinlichkeit von einem Abstand der einzelnen Segmente der ersten und/oder zweiten Gruppe zu einem Grenzpunkt, an dem die beiden Abschnitte der Gitterlinie aneinander angrenzen, ab. Ferner können die erste Wahrscheinlichkeit und die zweite Wahrscheinlichkeit auch von einem Differenzwinkel, d.h. der Abweichung des ersten bzw. zweiten vorbestimmten Winkels vom (lokalen) Tangentenwinkel innerhalb der beiden Abschnitte der Gitterlinie, abhängen. Beispielsweise nehmen in letzterem Fall die erste Wahrscheinlichkeit und die zweite Wahrscheinlichkeit jeweils ausgehend von einem Maximalwert (z.B. 100 %) für den Differenzwinkel 0° (d.h. der erste bzw. zweite vorbestimmte Winkel stimmt mit dem lokalen Tangentenwinkel überein) über einen im Vergleich zum Maximalwert kleineren Wert (z.B. 50 %) für einen Differenzwinkel, der dem über den ersten und zweiten vorbestimmten Winkel gemittelten Winkel entspricht, zu einem Minimalwert (z.B. 0 %) für einen weiteren Differenzwinkel, der dem jeweils anderen vorbestimmten Winkel entspricht, ab.

Es ist vorteilhaft, wenn die erste Wahrscheinlichkeit und/oder die zweite Wahrscheinlichkeit jeweils einen sich über zumindest einen Teil der Segmente der ersten und zweiten Gruppe erstreckenden Verlauf haben. Somit kann der Grad der stochastischen Verschmierung insbesondere über eine durch die Grenzpunkte definierte Grenzlinie hinweg entsprechend eingestellt werden.

Vorzugsweise haben der Verlauf der ersten Wahrscheinlichkeit und/oder der Verlauf der zweiten Wahrscheinlichkeit jeweils eine linear, sinusförmig oder exponentiell abfallende Flanke. Der Verlauf der ersten bzw. zweiten Wahrscheinlichkeit kann auch durch andere mathematische Funktionen gegeben sein, insbesondere eine Flanke haben, die durch eine zum Grenzpunkt punktsymmetrische Funktion gekennzeichnet ist.

Es ist vorteilhaft, wenn die Segmente von mindestens zwei benachbarten Gitterlinien Positionen haben, die entlang einer Längsausdehnung der Gitterlinien relativ zueinander versetzt sind, und wenn der Versatz dieser Positionen entlang der Längsausdehnung der Gitterlinien zufällig gewählt ist. Durch die stochastische Variation der Positionen der Segmente kann ein zweidimensionales Übergitter, das aufgrund einer regelmäßigen Anordnung von Kanten aneinandergrenzender Segmente einer Vielzahl von Gitterlinien entsteht, vermieden werden. Infolgedessen können auch unerwünschte Beugungseffekte, die durch solch ein Übergitter bewirkt werden, vermieden oder zumindest unterdrückt werden.

Ferner ist es vorteilhaft, wenn die Segmente zur Approximation der Gitterlinien jeweils durch eine Zellprojektion unter Verwendung von verschiedenen einzeln auswählbaren Retikeln auf einer Substratoberfläche erzeugte Belichtungsbereiche sind. Durch die Verwendung von Retikeln zur Erzeugung der Segmente mit jeweils unterschiedlicher Ausrichtung kann einerseits eine hohe Genauigkeit der Approximation erreicht werden, und andererseits kann die Anzahl der für die Approximation erforderlichen Segmente signifikant reduziert werden.

Vorzugsweise sind der eine oder die mehreren der Winkel der Längsachsen der Segmente der ersten Gruppe und/oder der eine oder die mehreren der Winkel der Längsachsen der Segmente der zweiten Gruppe jeweils zufällig aus der Gesamtheit des ersten vorbestimmten Winkels und des zweiten vorbestimmten Winkels ausgewählt (sog. Zweiwinkelmischung). Ferner können die vorgenannten Winkel auch jeweils zufällig aus der Gesamtheit des ersten vorbestimmten Winkels, des zweiten vorbestimmten Winkels und eines von dem ersten vorbestimmten Winkel und dem zweiten vorbestimmten Winkel verschiedenen dritten vorbestimmten Winkels ausgewählt sein (sog. Dreiwinkelmischung). Auch eine Mischung von mehr als drei Winkeln, d.h. eine Vierwinkelmischung oder höher, ist möglich.

Durch die oben genannte Mehrwinkelmischung, d.h. zumindest die Zweiwinkelmischung, wird der Effekt der stochastischen Verschmierung bewirkt.

Die erfindungsgemäße Gitterstruktur dient insbesondere als Maske (d.h. Fotomaske) für ein Lithographieverfahren, mit deren Hilfe die Massenfertigung von entsprechenden Gitterstrukturen im Kopierverfahren erfolgt.

Weitere Einzelheiten und Vorteile der Erfindung seien anhand der nachfolgenden Beschreibung von Ausführungsbeispielen in Verbindung mit den Figuren erläutert.

### KURZE BESCHREIBUNG DER ZEICHNUNGEN

Es zeigt
- Fig. 1: eine schematische Darstellung einer Anordnung zur Durchführung einer Zellprojektion unter Verwendung eines Retikels zur Erzeugung eines Segments zur Approximation einer Gitterlinie einer erfindungsgemäßen Gitterstruktur;
- Fig. 2: eine Draufsicht auf eine plattenförmige Blendenstruktur der in Fig. 1 gezeigten Anordnung mit verschiedenen einzeln auswählbaren Retikeln;
- Fig. 3: eine Darstellung von Gitterlinien einer erfindungsgemäßen Gitterstruktur;
- Fig. 4: eine Darstellung einer Gitterlinie der erfindungsgemäßen Gitterstruktur, wobei die Gitterlinie durch mehrere aufeinanderfolgende Segmente einer ersten und zweiten Gruppe approximiert ist;
- Fig. 5: eine schematische Darstellung zur Veranschaulichung einer stochastischen Verschmierung der Ausrichtungen von Segmenten der ersten und zweiten Gruppe;
- Fig. 6: eine schematische Darstellung zur Veranschaulichung eines sich zumindest über einen Teil der Segmente der ersten und zweiten Gruppe erstreckenden Wahrscheinlichkeitsverlaufs;
- Fig. 7: eine Darstellung zweier benachbarter Gitterlinien der erfindungsgemäßen Gitterstruktur, wobei die Gitterlinien jeweils durch mehrere aufeinanderfolgende Segmente approximiert sind, deren Positionen einen stochastischen Versatz relativ zueinander haben;
- Fig.8: eine schematische Darstellung zur Veranschaulichung einer unregelmäßigen Anordnung von Approximationsecken, die durch den stochastischen Positionsversatz nach Fig. 7 entsteht;
- Fig. 9: eine Darstellung einer Gitterlinie der erfindungsgemäßen Gitterstruktur, wobei die Gitterlinie durch mehrere aufeinanderfolgende, jeweils parallelogrammförmig ausgebildete Segmente einer ersten und zweiten Gruppe approximiert ist.

### BESCHREIBUNG DER AUSFÜHRUNGSFORMEN

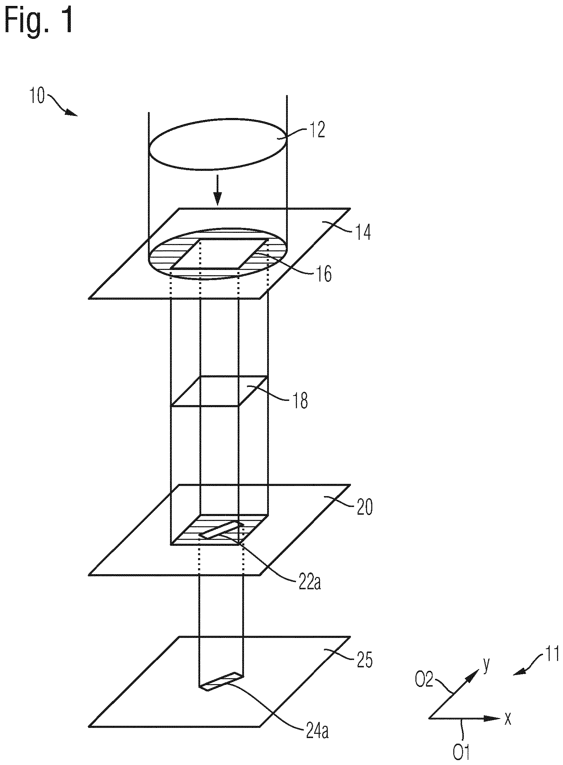

Fig. 1 zeigt eine schematische Darstellung einer Anordnung 10 zur Durchführung einer Zellprojektion (cell projection, CP) unter Verwendung eines Retikels 22a zur Erzeugung eines Segments 24a zur Approximation einer Gitterlinie einer erfindungsgemäßen Gitterstruktur. Die Anordnung 10 nach Fig. 1 umfasst eine erste plattenförmige Blendenstruktur 14 und eine zweite plattenförmige Blendenstruktur 20. Die erste plattenförmige Blendenstruktur 14 hat eine quadratische Blendenöffnung 16. Die zweite plattenförmige Blendenstruktur 20 umfasst das Retikel 22a, das als rechteckförmige (starre) Blendenöffnung ausgebildet ist. Das Retikel 22a ist eines von mehreren einzeln auswählbaren Retikeln, die verschiedene Ausrichtungen, d.h. Winkel ihrer Längsachsen relativ zu einer der beiden Koordinatenachsen O1, O2 eines Referenzkoordinatensystems 11, haben.

In Fig. 1 ist ein von einer Elektronenquelle erzeugter Elektronenstrahl 12 gezeigt. Der Elektronenstrahl 12 hat einen runden Strahlquerschnitt. Nach Durchtritt des Elektronenstrahls 12 durch die quadratische Blendenöffnung 16 der ersten plattenförmigen Blendenstruktur 14 wird aus dem runden Strahlquerschnitt ein quadratischer Ausschnitt 18 erzeugt. Der quadratische Ausschnitt 18 trifft auf die zweite plattenförmige Blendenstruktur 20. Nach Durchtritt des quadratischen Ausschnitts 18 durch das Retikel 22a der zweiten plattenförmigen Blendenstruktur 20 wird aus dem quadratischen Ausschnitt 18 ein dem Retikel 22a entsprechendes, rechteckförmig ausgebildetes Segment 24a (z.B. Strichsegment mit einem bestimmten Neigungswinkel) erzeugt. Das Segment 24a wird auf eine Substratoberfläche 25 projiziert. Die Substratoberfläche 25 kann mit Hilfe eines XY-Verfahrtisches in x-Richtung, d.h. parallel zur ersten Koordinatenachse O1 des Referenzkoordinatensystems 11, bzw. in y-Richtung, d.h. parallel zur zweiten Koordinatenachse O2 des Referenzkoordinatensystems 11, bewegt werden.

Durch die anhand von Fig. 1 erläuterte Zellprojektion kann die zu approximierende Gitterlinie, insbesondere eine schräge (gerade) oder teilweise gekrümmte Linie der Gitterstruktur, unter Verwendung einer minimalen Anzahl von Segmenten approximiert werden.

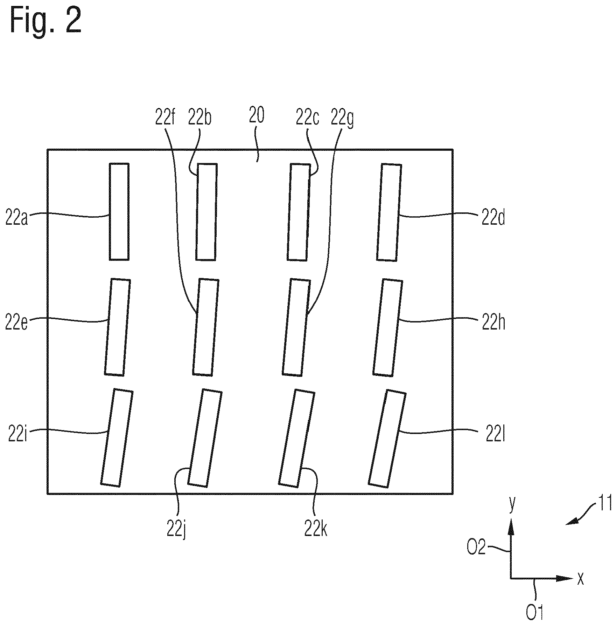

Fig. 2 zeigt eine Draufsicht auf die zweite plattenförmige Blendenstruktur 20 der in Fig. 1 gezeigten Anordnung 10 mit verschiedenen einzeln auswählbaren Retikeln 22a bis 22l. Die Retikel 22a bis 22l haben jeweils eine gleiche Rechteckform. Ferner haben die Retikel 22a bis 22l unterschiedliche Ausrichtungen, d.h. Winkel der Längsachsen relativ zu den beiden Koordinatenachsen O1, O2 des Referenzkoordinatensystems 11. Beispielsweise liegen die Winkel der Längsachsen der Retikel 22a bis 22l relativ zur zweiten Koordinatenachse O2 in einem Winkelbereich von 0° bis 11° mit einer Winkelabstufung von 1°. Für eine insgesamt gute Approximation der Gitterlinie, insbesondere einer gekrümmten Linie, sollte eine Vielzahl von Retikeln mit jeweils unterschiedlicher Ausrichtung (bzw. Neigung) vorgehalten werden. Der Wert für die Winkelabstufung ist von der gewünschten Approximationsgüte abhängig. Je kleiner der Wert für die Winkelabstufung ist, desto größer ist die erzielbare Approximationsgüte. Die Approximationsgüte wird jedoch durch die mögliche Anzahl der verschiedenen Retikel, die durch die in Fig. 1 gezeigte Anordnung 10 ansteuerbar sind, begrenzt.

Anstelle eines konstanten Wertes für die Winkelabstufung (z.B. Winkelabstufung von 1°) kann auch ein veränderlicher Wert für die Winkelabstufung vorgesehen sein.

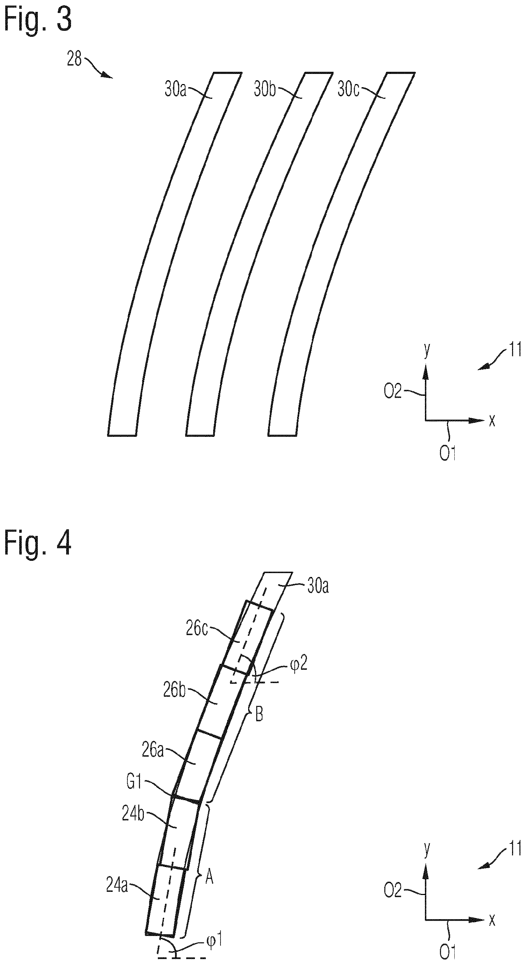

Fig. 3 zeigt eine Darstellung von Gitterlinien 30a bis 30c einer erfindungsgemäßen Gitterstruktur 28. Die Gitterlinien 30a bis 30c stellen insbesondere gekrümmte Linien dar, die in Bezug auf das Referenzkoordinatensystem 11 eine im Wesentlichen gleiche Neigung bzw. Ausrichtung haben. Die Gitterlinien 30a bis 30c bilden eine regelmäßige Anordnung, die als Maske für ein Lithographieverfahren dient, mit deren Hilfe die Massenfertigung der entsprechenden Gitterstrukturen im Kopierverfahren erfolgt.

Fig. 4 zeigt eine Darstellung der Gitterlinie 30a der Gitterstruktur 28, wobei die Gitterlinie 30a durch mehrere aufeinanderfolgende Segmente 24a, 24b bzw. 26a bis 26c einer ersten und zweiten Gruppe approximiert ist. Die Längsachsen der Segmente 24a, 24b bzw. 26a bis 26c haben jeweils einen Winkel (d.h. Neigungswinkel ϕ) relativ zur ersten Koordinatenachse O1 des Referenzkoordinatensystems 11. Die Gitterlinie 30a hat einen ersten Abschnitt A und einen an den ersten Abschnitt A angrenzenden zweiten Abschnitt B. Der erste Abschnitt A der Gitterlinie 30a wird durch die erste Gruppe von Segmenten 24a, 24b approximiert. Der zweite Abschnitt B der Gitterlinie 30a wird durch die zweite Gruppe von Segmenten 26a bis 26c approximiert. Die Längsachse des ersten Segments 24a der ersten Gruppe hat einen ersten vorbestimmten Winkel ϕ1 relativ zur ersten Koordinatenachse O1 des Referenzkoordinatensystems 11. Die Längsachse des letzten Segments 26c der zweiten Gruppe hat einen von dem ersten vorbestimmten Winkel ϕ1 verschiedenen zweiten vorbestimmten Winkel ϕ2 relativ zur ersten Koordinatenachse O1 des Referenzkoordinatensystems 11. Der erste vorbestimmte Winkel ϕ1 entspricht einer der Position des ersten Segments 24a zugeordneten Neigung der Gitterlinie 30a. Der zweite vorbestimmte Winkel ϕ2 entspricht einer der Position des letzten Segments 26c zugeordneten Neigung der Gitterlinie 30a. D.h., der erste vorbestimmte Winkel ϕ1 und der zweite vorbestimmte Winkel ϕ2 geben die jeweils unterschiedliche Neigung an der Position des ersten Segments 24a bzw. an der Position des letzten Segments 26c an. Wie in Fig. 4 gezeigt, grenzen die beiden Abschnitte A, B der Gitterlinie 30a an einem Grenzpunkt G1 aneinander an. Dabei ist eine im Grenzpunkt G1 definierte Neigung der Gitterlinie 30a durch einen Winkel (d.h. Tangentenwinkel) relativ zur ersten Koordinatenachse O1 des Referenzkoordinatensystems 11 gegeben, der einem über den ersten vorbestimmten Winkel ϕ1 und den zweiten vorbestimmten Winkel ϕ2 gemittelten Winkel entspricht.

Der Winkel der Längsachse des Segments 24b der ersten Gruppe und/oder die Winkel der Längsachsen eines oder beider Segmente 26a, 26b der zweiten Gruppe sind jeweils zufällig aus der Gesamtheit des ersten vorbestimmten Winkels ϕ1 und des zweiten vorbestimmten Winkels ϕ2 ausgewählt. Somit entsprechen die den Segmenten 24b bzw. 26a, 26b zugeordneten Winkel jeweils dem ersten vorbestimmten Winkel ϕ1 oder dem zweiten vorbestimmten Winkel ϕ2. Dadurch können die Ausrichtungen der Segmente 24b bzw. 26a, 26b insbesondere in der Nähe des Grenzpunkts G1 stochastisch verschmiert werden.

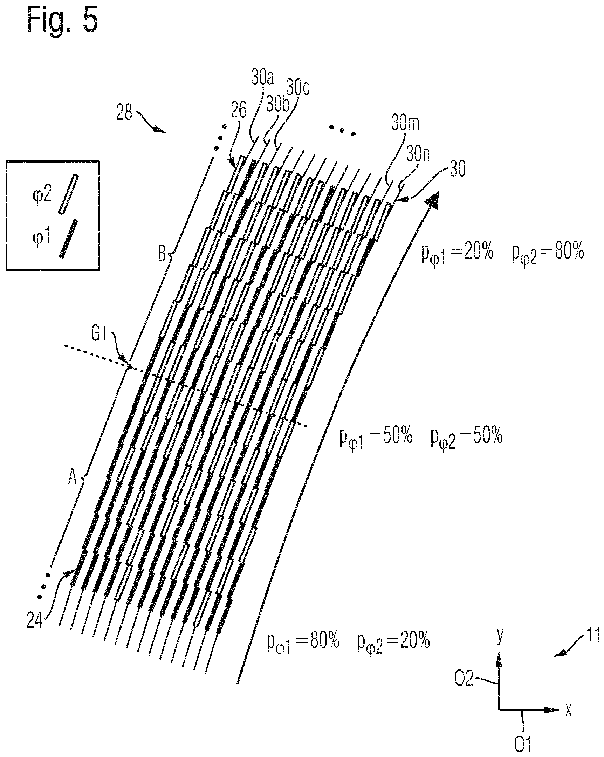

Fig. 5 zeigt eine schematische Darstellung zur Veranschaulichung einer stochastischen Verschmierung der Ausrichtungen der Segmente 24, 26 der ersten und zweiten Gruppe. Die Segmente 24, 26 der Gitterlinien 30a bis 30n (Gitterlinien 30) in Fig. 5 entsprechen jeweils den Segmenten 24a, 24b bzw. 26a bis 26c der Gitterlinie 30a in Fig. 4. In Fig. 5 sind zudem die beiden Abschnitte A, B der Gitterlinien 30, die an den Grenzpunkten G1 (vgl. die gestrichelte Linie in Fig. 5) aneinander angrenzen, gezeigt.

Gemäß Fig. 5 haben die Längsachsen eines Hauptanteils der Segmente 24 der ersten Gruppe den ersten vorbestimmten Winkel ϕ1 relativ zur ersten Koordinatenachse O1 des Referenzkoordinatensystems 11, während die Längsachsen eines Hauptanteils der Segmente 26 der zweiten Gruppe den zweiten vorbestimmen Winkel ϕ2 relativ zur ersten Koordinatenachse O1 des Referenzkoordinatensystems 11 haben. Ferner ist anhand von Fig. 5 veranschaulicht, dass einer oder mehrere der Winkel der Längsachsen der Segmente 24 der ersten Gruppe und/oder einer oder mehrere der Winkel der Längsachsen der Segmente der zweiten Gruppe 26 jeweils zufällig aus der Gesamtheit des ersten vorbestimmten Winkels ϕ1 und des zweiten vorbestimmen Winkels ϕ2 ausgewählt sind. Die Auswahl des ersten vorbestimmten Winkels ϕ1 ist in Fig. 5 jeweils durch ein ausgefülltes Rechteck dargestellt, während die Auswahl des zweiten vorbestimmten Winkels ϕ2 jeweils durch ein nichtausgefülltes Rechteck dargestellt ist.

Vorzugsweise entsprechen die zufällig ausgewählten Winkel der Längsachsen der Segmente 24, 26 der ersten und/oder zweiten Gruppe jeweils mit einer ersten Wahrscheinlichkeit p_{ϕ1} dem ersten vorbestimmten Winkel ϕ1 und mit einer zweiten Wahrscheinlichkeit p_{ϕ2} dem zweiten vorbestimmten Winkel ϕ2. Bezugnehmend auf Fig. 5 betragen die erste und zweite Wahrscheinlichkeit in der Nähe der Mitte des ersten Abschnitts A 80% bzw. 20%, während die erste und zweite Wahrscheinlichkeit in der Nähe der Mitte des zweiten Abschnitts B 20% bzw. 80% betragen. Beim Grenzpunkt G1 (gestrichelte Linie) betragen die erste und zweite Wahrscheinlichkeit jeweils 50%. Somit nimmt die erste Wahrscheinlichkeit von der Mitte des ersten Abschnitts A zur Mitte des zweiten Abschnitts B hin ab, während die zweite Wahrscheinlichkeit von der Mitte des zweiten Abschnitts B zur Mitte des ersten Abschnitts A hin abnimmt. Ferner sind die erste und zweite Wahrscheinlichkeit am Grenzpunkt G1 gleich groß, so dass dort die stochastische Verschmierung am größten ist.

Insbesondere hängen die erste und zweite Wahrscheinlichkeit jeweils von einem Abstand der einzelnen Segmente 24, 26 der ersten bzw. zweiten Gruppe zum Grenzpunkt G1 ab. Dabei nimmt die erste Wahrscheinlichkeit mit kleiner werdendem Abstand der in Fig. 5 gezeigten, einzelnen Segmente 24 der ersten Gruppe zum Grenzpunkt G1 hin ab. Ferner nimmt die zweite Wahrscheinlichkeit mit kleiner werdendem Abstand der in Fig. 5 gezeigten, einzelnen Segmente 26 der zweiten Gruppe zum Grenzpunkt G1 hin ab. Bei einem minimalen Abstand eines einzelnen Segments der ersten Gruppe zum Grenzpunkt G1 und/oder bei einem minimalen Abstand eines einzelnen Segments der zweiten Gruppe zum Grenzpunkt G1 (d.h. für die jeweils an den Grenzpunkt G1 angrenzenden Segmente 24, 26 der ersten bzw. zweiten Gruppe) betragen die erste und zweite Wahrscheinlichkeit jeweils 50%.

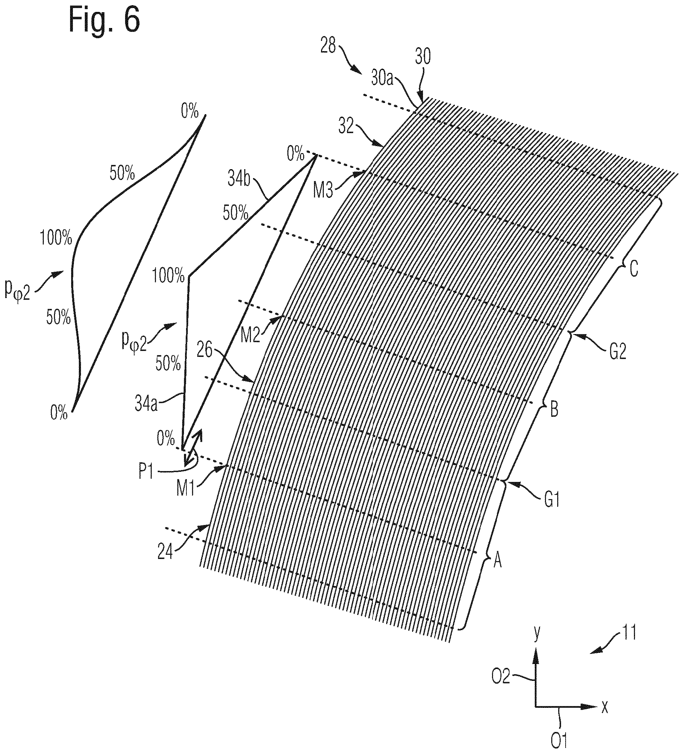

Fig. 6 zeigt eine schematische Darstellung zur Veranschaulichung eines sich zumindest über einen Teil der Segmente 24, 26 der ersten und zweiten Gruppe erstreckenden Wahrscheinlichkeitsverlauf (p_{ϕ2}). In Fig. 6 ist zusätzlich zu den Abschnitten A, B der Gitterlinie 30a ein weiterer Abschnitt C der Gitterlinie 30a gezeigt. Die Abschnitte A, B grenzen an den Grenzpunkten G1 aneinander an, während die Abschnitte B, C an den weiteren Grenzpunkten G2 aneinander angrenzen. Die Abschnitte A, B umfassen die Segmente 24, 26 der ersten bzw. zweiten Gruppe, während der Abschnitt C weitere Segmente 32 einer dritten Gruppe umfasst, wobei die Längsachsen eines Hauptanteils der Segmente 32 der dritten Gruppe einen von dem ersten und zweiten vorbestimmten Winkel ϕ1, ϕ2 verschiedenen dritten vorbestimmten Winkel (ϕ3) relativ zur ersten Koordinatenachse O1 des Referenzkoordinatensystems 11 haben. Ferner sind in Fig. 6 die Mittelpunkte M1 bis M3 der entsprechenden Abschnitte A bis C gezeigt.

Insbesondere zeigt Fig. 6 eine makroskopische Ansicht der Gitterstruktur 28. Die Gitterstruktur 28 nach Fig. 6 besteht aus Millionen oder gar Milliarden einzelner mikroskopischer Segmente.

In Fig. 6 ist lediglich der Verlauf der zweiten Wahrscheinlichkeit p_{ϕ2}, der ein Maximum beim Mittelpunkt M2 hat, dargestellt. Die nachfolgenden Erläuterungen gelten jedoch analog auch für den Verlauf der ersten Wahrscheinlichkeit p_{ϕ1}, der ein Maximum beim Mittelpunkt M1 hat und in Fig. 6 nicht dargestellt ist.

Wie in Fig. 6 gezeigt, hat der Verlauf der zweiten Wahrscheinlichkeit ein Maximum (z.B. Maximalwert von 100%) beim Mittelpunkt M2 und zwei Minima (z.B. Minimalwerte von 0%) bei den Mittelpunkten M1 bzw. M3. Ferner hat der Verlauf der zweiten Wahrscheinlichkeit zwei linear abfallende Flanken 34a, 34b. An den Grenzpunkten G1, G2 betragen die Werte der abfallenden Flanken 34a, 34b beispielsweise jeweils 50%. Anstelle der linear abfallenden Flanken 34a, 34b kann der Verlauf der zweiten Wahrscheinlichkeit auch eine andere Form haben, wie es in Fig. 6 angedeutet ist. Insbesondere kann der Verlauf der zweiten Wahrscheinlichkeit auch sinusförmig oder exponentiell abfallende Flanken haben. Darüber hinaus kann der Verlauf der zweiten Wahrscheinlichkeit auch dahingehend geändert bzw. angepasst werden, dass die bei den Mittelpunkten M1 und M3 liegenden Minima zum oder weg vom Abschnitt B verschoben sind. Dies ist in Fig. 6 durch den Doppelpfeil P1 angedeutet.

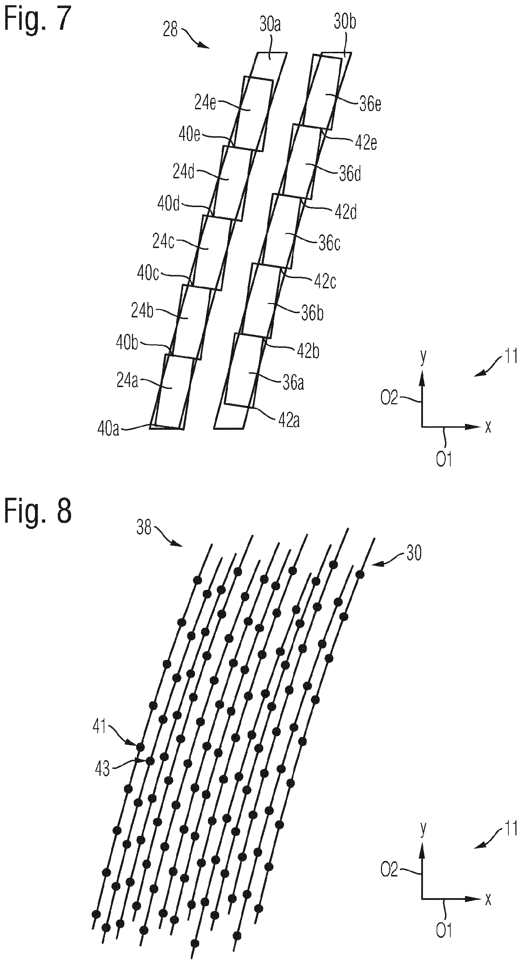

Fig. 7 zeigt eine Darstellung der beiden benachbarten Gitterlinien 30a, 30b der Gitterstruktur 28. Jeder der beiden Gitterlinien 30a, 30b ist durch mehrere aufeinanderfolgende Segmente 24a bis 24e bzw. 36a bis 36e (Segmente 24, 36) approximiert. Wie in Fig. 7 gezeigt, haben die Segmente 24a bis 24e und 36a bis 36e Positionen, insbesondere Anfangspositionen 40a bis 40e bzw. 42a bis 42e, die entlang einer Längsausdehnung der Gitterlinien 30a, 30b relativ zueinander versetzt sind. Dabei ist der Versatz dieser Positionen 40a bis 40e und 42a bis 42e (Positionen 40 bzw. 42) entlang der Längsausdehnung der Gitterlinien 30a, 30b zufällig gewählt.

Fig. 8 zeigt eine schematische Darstellung zur Veranschaulichung einer unregelmäßigen Anordnung 38 von Approximationsecken, d.h. Kanten der an den Positionen 40, 42 aneinandergrenzenden Segmente 24, 36, die durch den anhand von Fig. 7 erläuterten stochastischen Positionsversatz entsteht. In Fig. 8 sind die an den Positionen 40 und 42 liegenden Approximationsecken 41 bzw. 43 durch Punkte dargestellt, durch die die Gitterlinien 30 verlaufen. Wie in Fig. 8 gezeigt, unterscheidet sich der stochastische Positionsversatz von Gitterlinie zu Gitterlinie jeweils derart, dass eine gleichsam amorphe Anordnung 38 der Approximationsecken 41, 43 gebildet wird. Dadurch kann die Bildung eines zweidimensionalen Übergitters, das aufgrund einer gleichsam kristallinen Anordnung von Approximationsecken entsteht, effektiv unterdrückt werden. Folglich können auch unerwünschte Beugungseffekte, die an solch einem Übergitter auftreten, weitgehend ausgeblendet werden.

Fig. 9 zeigt eine weitere Darstellung der Gitterlinie 30a der Gitterstruktur 28. Die Gitterlinie 30a ist wiederum durch mehrere aufeinanderfolgende Segmente 24a, 24b bzw. 26a bis 26c der ersten und zweiten Gruppe approximiert. Anstelle der rechteckförmig ausgebildeten Segmente 24a, 24b und 26a bis 26c zur Approximation der Gitterlinie 30a nach Fig. 4 sind die Segmente 24a, 24b und 26a bis 26c zur Approximation der Gitterlinie 30a nach Fig. 9 jeweils parallelogrammförmig ausgebildet. Wie in Fig. 9 gezeigt, sind kurze Seiten 44a bis 44f der parallelogrammförmig ausgebildeten Segmente 24a, 24b bzw. 26a bis 26c (Segmente 24, 26) jeweils parallel zur ersten Koordinatenachse O1 des Referenzkoordinatensystems 11. Ferner haben die in Fig. 9 gezeigten Segmente 24, 26 jeweils eine gleiche Ausdehnung (Δy) entlang der zur ersten Koordinatenachse O1 orthogonal verlaufenden zweiten Koordinatenachse O2 des Referenzkoordinatensystems 11. Durch die Verwendung der Parallelogrammform können Überlappungsfehler, d.h. Bereiche, in denen bei den Kanten aneinandergrenzender Segmente eine unerwünschte Überlappung bzw. ein Nichtaneinandergrenzen der Segmente erfolgt, vermieden werden.

Falls eine Approximation nahezu waagrechter Gitterlinien, d.h. Winkel der Längsausdehnung der Gitterlinien relativ zur zweiten Koordinatenachse O2 größer als 45°, erfolgt, können die parallelogrammförmig ausgebildeten Segmente 24, 26 auch derart ausgebildet sein, dass deren kurze Seiten anstatt jeweils parallel zur ersten Koordinatenachse O1 des Referenzkoordinatensystems 11 zu sein, jeweils parallel zur zweiten Koordinatenachse O2 des Referenzkoordinatensystems 11 sind.

Bei der Erfindung erfolgt die Approximation der Gitterlinien durch die Segmente im Gegensatz zum Stand der Technik nicht in Abhängigkeit einer zu erzielenden minimalen Kantenrauheit, sondern vorzugsweise unter Verwendung einer stochastischen Verschmierung (d.h. stochastisches Mischen) der Ausrichtungen der Segmente. In ersterem Fall ergibt sich nämlich eine abrupte Änderung der Ausrichtungen der Segmente an den Grenzpunkten zwischen jeweils benachbarten Abschnitten der Gitterlinien. Dies bewirkt wiederum den makroskopischen Effekt einer an den Abschnitts- bzw. Zonengrenzen auftretenden sprunghaften Veränderung der Lichtbeugung. Durch die stochastische Verschmierung kann dieser Effekt jedoch vermieden werden. Erfindungsgemäß erfolgt die stochastische Verschmierung bereits vor der durch die Grenzpunkte definierten Grenzlinie (d.h. Umschaltlinie). Je näher sich die Segmente an der Grenzlinie befinden, desto höher ist der Grad der stochastischen Verschmierung. Direkt an der Umschaltlinie beträgt die Wahrscheinlichkeit für die Einstellung bzw. Auswahl der entsprechenden Ausrichtungen jeweils 50%. Die Mischungszone ist durch den Verlauf der stochastischen Wahrscheinlichkeiten, insbesondere ausgehend von einem Maximum (Wahrscheinlichkeit 100%) jeweils beispielsweise linear oder sinusförmig abfallend, gekennzeichnet. Für eine möglichst breite stochastische Verschmierung wird der Beginn der Mischungszone, d.h. der Punkt, an dem die jeweilige Wahrscheinlichkeit 0% beträgt, vorzugsweise an die Positionen gesetzt, an denen die Neigung der Gitterlinien durch entsprechende vorbestimmte Winkel gegeben ist, d.h. ungefähr in die Mitte der jeweiligen Nachbarzone.

Der Punkt, an dem die jeweilige Wahrscheinlichkeit 0% beträgt, kann jedoch auch beliebig nach außen oder innen verschoben werden. Dies sollte dann analog für sämtliche vorkommende Winkelstufen, d.h. für alle den entsprechenden Abschnitten bzw. Zonen zugeordnete Wahrscheinlichkeitsverläufe erfolgen. Insbesondere bei einer Verschiebung des Punktes nach außen sollte dann eine Dreiwinkelmischung erfolgen. Es kann auch eine Vierwinkelmischung erfolgen, vorzugsweise in der Nähe der Grenzlinie. Bei der Dreiwinkel- bzw. Vierwinkelmischung sollten sich zumindest die den jeweils benachbarten Abschnitten zugeordneten Wahrscheinlichkeitsverläufe und die einem oder zwei weiteren Abschnitten (d.h. übernächste Abschnitte, die den erstgenannten Abschnitten jeweils benachbart sind und sich in Bezug auf diese Abschnitte gegenüberliegen) zugeordneten Wahrscheinlichkeitsverläufe zumindest teilweise überlappen.

Insgesamt erhöht sich bei der Erfindung zwar die effektive Kantenrauheit, aber der scharfe mikroskopische Winkelübergang (d.h. die abrupte Ausrichtungsänderung) zwischen den Zonen wird verschmiert. Der Verlauf der Wahrscheinlichkeiten kann auch durch andere mathematische Funktionen gegeben sein, d.h. er ist insbesondere nicht auf linear oder sinusförmig abfallende Flanken beschränkt. Zur Reduzierung der Kantenrauheit kann des Weiteren eine 2-fach-Pass- oder Mehrfach-Pass-Belichtung erfolgen.

Die erfindungsgemäße Gitterstruktur (bzw. eine im Kopierverfahren hergestellte Gitterstruktur) eignet sich für den Einsatz in einer diffraktiven Optik, wie beispielsweise in diffraktiven optischen Elementen oder in einem Beugungsgitter.

### Bezugszeichenliste

- 10: Anordnung
- 11: Referenzkoordinatensystem
- 12: Elektronenstrahl
- 14: plattenförmige Blendenstruktur
- 16: quadratische Blendenöffnung
- 18: quadratischer Ausschnitt
- 20: plattenförmige Blendenstruktur
- 22a - 22l: Retikel
- 24a - 24e (24): Segment
- 25: Substratoberfläche
- 26a - 26c (26): Segment
- 28: Gitterstruktur
- 30a - 30n (30): Gitterlinie
- 32: Segmente
- 34a, 34b: Flanke
- 36a - 36e (36): Segment
- 38: amorphe Anordnung
- 40a - 40e (40): Position
- 41: Approximationsecken
- 42a - 42e (42): Position
- 43: Approximationsecken
- 44a - 44f: kurze Seite
- A - C: Abschnitt
- G1, G2: Grenzpunkt
- M1 - M3: Mittelpunkt
- O1, O2: Koordinatenachse
- P1: Doppelpfeil
- p_{ϕ1}, p_{ϕ2}: Wahrscheinlichkeit
- Δy: Ausdehnung
- ϕ1, ϕ2: vorbestimmter Winkel

## Patentansprüche

1. Gitterstruktur (28) für eine diffraktive Optik,
mit mehreren Gitterlinien (30), wobei jede Gitterlinie (30a bis 30n) durch mehrere aufeinanderfolgende Segmente (24, 26; 36) approximiert ist, wobei Längsachsen der Segmente (24, 26; 36) jeweils einen Winkel relativ zu einer ersten Koordinatenachse (O1) eines Referenzkoordinatensystems (11) haben,
wobei ein erster Abschnitt (A) einer Gitterlinie (30a) durch eine erste Gruppe von Segmenten (24) und ein an den ersten Abschnitt (A) angrenzender zweiter Abschnitt (B) der Gitterlinie (30a) durch eine zweite Gruppe von Segmenten (26) approximiert sind,
**dadurch gekennzeichnet, dass** die Längsachsen eines Hauptanteils der Segmente (24) der ersten Gruppe einen ersten vorbestimmten Winkel (ϕ1) relativ zur ersten Koordinatenachse (O1) des Referenzkoordinatensystems (11) und die Längsachsen eines Hauptanteils der Segmente (26) der zweiten Gruppe einen von dem ersten vorbestimmten Winkel (ϕ1) verschiedenen zweiten vorbestimmten Winkel (ϕ2) relativ zur ersten Koordinatenachse (O1) des Referenzkoordinatensystems (11) haben, und dass einer oder mehrere der Winkel der Längsachsen der Segmente (24) der ersten Gruppe und/oder einer oder mehrere der Winkel der Längsachsen der Segmente (26) der zweiten Gruppe jeweils zufällig aus der Gesamtheit zumindest des ersten vorbestimmten Winkels (ϕ1) und des zweiten vorbestimmten Winkels (ϕ2) ausgewählt sind.

2. Gitterstruktur (28) nach Anspruch 1, **dadurch gekennzeichnet, dass** die zufällig ausgewählten Winkel der Längsachsen der Segmente (24, 26) der ersten und/oder zweiten Gruppe jeweils mit einer ersten Wahrscheinlichkeit (p_{ϕ1}) dem ersten vorbestimmten Winkel (ϕ1) und mit einer zweiten Wahrscheinlichkeit (p_{ϕ2}) dem zweiten vorbestimmten Winkel (ϕ2) entsprechen.

3. Gitterstruktur (28) nach Anspruch 2, **dadurch gekennzeichnet, dass** die erste Wahrscheinlichkeit (p_{ϕ1}) und die zweite Wahrscheinlichkeit (p_{ϕ2}) von einem Abstand der einzelnen Segmente (24, 26) der ersten und/oder zweiten Gruppe zu einem Grenzpunkt (G1), an dem die beiden Abschnitte (A, B) der Gitterlinie (30a) aneinander angrenzen, abhängen,

4. Gitterstruktur (28) nach Anspruch 3, **dadurch gekennzeichnet, dass** die erste Wahrscheinlichkeit (p_{ϕ1}) mit kleiner werdendem Abstand zumindest eines Teils der einzelnen Segmente (24) der ersten Gruppe zum Grenzpunkt (G1) hin abnimmt.

5. Gitterstruktur (28) nach Anspruch 3 oder 4, **dadurch gekennzeichnet, dass** die zweite Wahrscheinlichkeit (p_{ϕ2}) mit kleiner werdendem Abstand zumindest eines Teils der einzelnen Segmente (26) der zweiten Gruppe zum Grenzpunkt (G1) hin abnimmt.

6. Gitterstruktur (28) nach einem der Ansprüche 3 bis 5, **dadurch gekennzeichnet, dass** die erste Wahrscheinlichkeit (p_{ϕ1}) und die zweite Wahrscheinlichkeit (p_{ϕ2}) bei einem minimalen Abstand eines einzelnen Segments der ersten Gruppe zum Grenzpunkt (G1) und/oder bei einem minimalen Abstand eines einzelnen Segments der zweiten Gruppe zum Grenzpunkt (G1) jeweils 0,5 betragen.

7. Gitterstruktur (28) nach einem der Ansprüche 2 bis 6, **dadurch gekennzeichnet, dass** die erste Wahrscheinlichkeit (p_{ϕ1}) und/oder die zweite Wahrscheinlichkeit (p_{ϕ2}) jeweils einen sich über zumindest einen Teil der Segmente (24, 26) der ersten und zweiten Gruppe erstreckenden Verlauf haben.

8. Gitterstruktur (28) nach Anspruch 7, **dadurch gekennzeichnet, dass** der Verlauf der ersten Wahrscheinlichkeit (p_{ϕ1}) und/oder der Verlauf der zweiten Wahrscheinlichkeit (p_{ϕ2)} jeweils ein Maximum bei einem an einem Mittelpunkt (M1, M2) des ersten beziehungsweise zweiten Abschnitts (A, B) der Gitterlinie (30a) liegenden Segments der ersten beziehungsweise zweiten Gruppe haben.

9. Gitterstruktur (28) nach Anspruch 7 oder 8, **dadurch gekennzeichnet, dass** der Verlauf der ersten Wahrscheinlichkeit (p_{ϕ1}) und/oder der Verlauf der zweiten Wahrscheinlichkeit (p_{ϕ2}) jeweils ein Minimum bei einem an einem Mittelpunkt (M2, M1) des zweiten beziehungsweise ersten Abschnitts (B, A) der Gitterlinie (30a) liegenden Segments der zweiten beziehungsweise ersten Gruppe haben.

10. Gitterstruktur (28) nach Anspruch 9, **dadurch gekennzeichnet, dass** das Minimum des Verlaufs der ersten Wahrscheinlichkeit (p_{ϕ1}) und/oder das Minimum des Verlaufs der zweiten Wahrscheinlichkeit (p_{ϕ2}) relativ zum Mittelpunkt (M2, M1) des zweiten beziehungsweise ersten Abschnitts (B, A) der Gitterlinie (30a) zum oder weg vom jeweils anderen Abschnitt (A, B) der Gitterlinie (30a) verschoben sind.

11. Gitterstruktur (28) nach einem der Ansprüche 7 bis 10, **dadurch gekennzeichnet, dass** der Verlauf der ersten Wahrscheinlichkeit (p_{ϕ1}) und/oder der Verlauf der zweiten Wahrscheinlichkeit (p_{ϕ2}) jeweils eine linear, sinusförmig oder exponentiell abfallende Flanke (34a) haben.

12. Gitterstruktur (28) nach einem der Ansprüche 1 bis 11, **dadurch gekennzeichnet, dass** die Segmente (24, 36) von mindestens zwei benachbarten Gitterlinien (30a, 30b) Positionen (40, 42) haben, die entlang einer Längsausdehnung der Gitterlinien (30a, 30b) relativ zueinander versetzt sind, und dass der Versatz dieser Positionen (40, 42) entlang der Längsausdehnung der Gitterlinien (30a, 30b) zufällig gewählt ist.

13. Gitterstruktur (28) nach einem der Ansprüche 1 bis 12, **dadurch gekennzeichnet, dass** die Segmente (24, 26) der ersten und zweiten Gruppe jeweils parallelogrammförmig ausgebildet sind, dass kurze Seiten (44a bis 44f) der parallelogrammförmig ausgebildeten Segmente (24, 26) jeweils parallel zur ersten Koordinatenachse (O1) des Referenzkoordinatensystems (11) sind, und dass die Segmente (24, 26) der ersten und zweiten Gruppe jeweils eine gleiche Ausdehnung (Δy) entlang einer zur ersten Koordinatenachse (O1) orthogonal verlaufenden zweiten Koordinatenachse (O1) des Referenzkoordinatensystems (11) haben.

14. Gitterstruktur (28) nach einem der Ansprüche 1 bis 13, **dadurch gekennzeichnet, dass** die Segmente (24, 26; 36) zur Approximation der Gitterlinien (30) jeweils durch eine Zellprojektion unter Verwendung von verschiedenen einzeln auswählbaren Retikeln (22) auf einer Substratoberfläche (25) erzeugte Belichtungsbereiche sind.

## Claims

1. Grating structure (28) for a diffractive optical unit,
having a plurality of grating lines (30), wherein each grating line (30a to 30n) is approximated by a plurality of successive segments (24, 26; 36), wherein longitudinal axes of the segments (24, 26; 36) each have an angle relative to a first coordinate axis (O1) of a reference coordinate system (11),
wherein a first section (A) of a grating line (30a) is approximated by a first group of segments (24) and a second section (B) of the grating line (30a) adjoining the first section (A) is approximated by a second group of segments (26),
**characterized in that** the longitudinal axes of a main portion of the segments (24) of the first group have a first predetermined angle (ϕ1) relative to the first coordinate axis (O1) of the reference coordinate system (11) and the longitudinal axes of a main portion of the segments (26) of the second group have a second predetermined angle (ϕ2), different from the first predetermined angle (ϕ1), relative to the first coordinate axis (O1) of the reference coordinate system (11), and **in that** one or more of the angles of the longitudinal axes of the segments (24) of the first group and/or one or more of the angles of the longitudinal axes of the segments (26) of the second group are each randomly selected from the totality of at least the first predetermined angle (ϕ1) and the second predetermined angle (ϕ2).

2. Grating structure (28) according to Claim 1, **characterized in that** the randomly selected angles of the longitudinal axes of the segments (24, 26) of the first and/or second group each correspond to the first predetermined angle (ϕ1) with a first probability (p_{ϕ1}) and to the second predetermined angle (ϕ2) with a second probability (p_{ϕ2}).

3. Grating structure (28) according to Claim 2, **characterized in that** the first probability (p_{ϕ1}) and the second probability (p_{ϕ2}) are dependent on a distance of the individual segments (24, 26) of the first and/or second group from a limit point (G1) at which both sections (A, B) of the grating line (30a) adjoin one another.

4. Grating structure (28) according to Claim 3, **characterized in that** the first probability (p_{ϕ1}) decreases with a decreasing distance of at least a part of the individual segments (24) of the first group from the limit point (G1).

5. Grating structure (28) according to Claim 3 or 4, **characterized in that** the second probability (p_{ϕ2}) decreases with a decreasing distance of at least a part of the individual segments (26) of the second group from the limit point (G1).

6. Grating structure (28) according to any of Claims 3 to 5, **characterized in that** the first probability (p_{ϕ1}) and the second probability (p_{ϕ2}) in the case of a minimum distance of an individual segment of the first group from the limit point (G1) and/or in the case of a minimum distance of an individual segment of the second group from the limit point (G1) are each 0.5.

7. Grating structure (28) according to any of Claims 2 to 6, **characterized in that** the first probability (p_{ϕ1}) and/or the second probability (p_{ϕ2}) each have a profile that extends over at least a part of the segments (24, 26) of the first and second groups.

8. Grating structure (28) according to Claim 7, **characterized in that** the profile of the first probability (p_{ϕ1}) and/or the profile of the second probability (p_{ϕ2}) each have a maximum at a segment of the first or second group that is located at a midpoint (M1, M2) of the first or second section (A, B) of the grating line (30a).

9. Grating structure (28) according to Claim 7 or 8, **characterized in that** the profile of the first probability (p_{ϕ1}) and/or the profile of the second probability (p_{ϕ2}) each have a minimum at a segment of the second or first group that is located at a midpoint (M1, M2) of the second or first section (B, A) of the grating line (30a).

10. Grating structure (28) according to Claim 9, **characterized in that** the minimum of the profile of the first probability (p_{ϕ1}) and/or the minimum of the profile of the second probability (p_{ϕ2}) are shifted relative to the midpoint (M2, M1) of the second or first section (B, A) of the grating line (30a) towards or away from the respective other section (A, B) of the grating line (30a) .

11. Grating structure (28) according to any of Claims 7 to 10, **characterized in that** the profile of the first probability (p_{ϕ1}) and/or the profile of the second probability (p_{ϕ2}) each have a linearly, sinusoidally or exponentially falling edge (34a).

12. Grating structure (28) according to any of Claims 1 to 11, **characterized in that** the segments (24, 36) of at least two adjacent grating lines (30a, 30b) have positions (40, 42) that are shifted relative to one another along a longitudinal extent of the grating lines (30a, 30b), and **in that** the shift of these positions (40, 42) along the longitudinal extent of the grating lines (30a, 30b) is randomly selected.

13. Grating structure (28) according to any of Claims 1 to 12, **characterized in that** the segments (24, 26) of the first and second groups each have the shape of a parallelogram, **in that** short sides (44a to 44f) of the parallelogram-shaped segments (24, 26) are each parallel to the first coordinate axis (O1) of the reference coordinate system (11), and **in that** the segments (24, 26) of the first and second groups each have the same extent (Δy) along a second coordinate axis (O1) of the reference coordinate system (11) extending orthogonally to the first coordinate axis (O1).

14. Grating structure (28) according to any of Claims 1 to 13, **characterized in that** the segments (24, 26; 36) for the approximation of the grating lines (30) are each exposure regions produced by a cell projection using different individually selectable reticles (22) on a substrate surface (25).

## Revendications

1. Structure formant grille (28) destinée à une optique diffractive, ladite structure formant grille comprenant
une pluralité de lignes de grille (30), chaque ligne de grille (30a à 30n) étant approximée par une pluralité de segments successifs (24, 26 ; 36), des axes longitudinaux des segments (24, 26 ; 36) formant chacun un angle par rapport à un premier axe de coordonnées (O1) d'un système de coordonnées de référence (11),
une première portion (A) d'une ligne de grille (30A) étant approximée par un premier groupe de segments (24) et une deuxième portion (B), adjacente à la première portion (A), de la ligne de grille (30a) étant approximée par un deuxième groupe de segments (26), **caractérisée en ce que** les axes longitudinaux d'une partie principale des segments (24) du premier groupe forment un premier angle prédéterminé (ϕ1) par rapport au premier axe de coordonnées (O1) du système de coordonnées de référence (11) et les axes longitudinaux d'une partie principale des segments (26) du deuxième groupe forment un deuxième angle prédéterminé (ϕ2), différent du premier angle prédéterminé (ϕ1), par rapport au premier axe de coordonnées (O1) du système de coordonnées de référence (11), et **en ce qu'**un ou plusieurs des angles formés par les axes longitudinaux des segments (24) du premier groupe et/ou un ou plusieurs des angles formés par les axes longitudinaux des segments (26) du deuxième groupe sont choisis aléatoirement à partir de l'ensemble formé par au moins le premier angle prédéterminé (ϕ1) et le deuxième angle prédéterminé (ϕ2).

2. Structure formant grille (28) selon la revendication 1, **caractérisée en ce que** les angles choisis aléatoirement, qui sont formés par les axes longitudinaux des segments (24, 26) du premier et/ou du deuxième groupe, correspondent respectivement au premier angle prédéterminé (ϕ1) avec une première probabilité (p_{ϕ1}) et au deuxième angle prédéterminé (ϕ₂) avec une deuxième probabilité (p_{ϕ2}).

3. Structure formant grille (28) selon la revendication 2, **caractérisée en ce que** la première probabilité (p_{ϕ1}) et la deuxième probabilité (p_{ϕ2}) dépendent d'une distance des segments individuels (24, 26) du premier et/ou du deuxième groupe à un point limite (G1) au niveau duquel les deux portions (A, B) de la ligne de grille (30a) sont adjacentes l'une à l'autre.

4. Structure formant grille (28) selon la revendication 3, **caractérisée en ce que** la première probabilité (p_{ϕ1}) diminue à mesure que la distance d'au moins une partie des segments individuels (24) du premier groupe au point limite (G1) devient plus petite.

5. Structure formant grille (28) selon la revendication 3 ou 4, **caractérisée en ce que** la deuxième probabilité (p_{ϕ2}) diminue à mesure que la distance d'au moins une partie des segments individuels (26) du deuxième groupe au point frontière (G1) devient plus petite.

6. Structure formant grille (28) selon l'une des revendications 3 à 5, **caractérisée en ce que**, pour une distance minimale d'un segment individuel du premier groupe au point limite (G1) et/ou pour une distance minimale d'un segment individuel du deuxième groupe au point limite (G1), la première probabilité (p_{ϕ1}) et la deuxième probabilité (p_{ϕ2}) sont à chaque fois de 0,5.

7. Structure formant grille (28) selon l'une des revendications 2 à 6, **caractérisée en ce que** la première probabilité (p_{ϕ1}) et/ou la deuxième probabilité (p_{ϕ2}) ont chacune un profil qui s'étend sur au moins une partie des segments (24, 26) des premier et deuxième groupes.

8. Structure formant grille (28) selon la revendication 7, **caractérisée en ce que** le profil de la première probabilité (p_{ϕ1}) et/ou le profil de la deuxième probabilité (p_{ϕ2})présentent chacun un maximum pour un segment du premier ou du deuxième groupe qui est situé en un point central (M1, M2) de la première ou la deuxième portion (A, B) de la ligne de grille (30a) .

9. Structure formant grille (28) selon la revendication 7 ou 8, **caractérisée en ce que** le profil de la première probabilité (p_{ϕ1}) et/ou le profil de la deuxième probabilité (p_{ϕ2}) présentent chacun un minimum pour un segment du deuxième ou premier groupe situé en un point central (M2, Ml) de la deuxième ou première portion (B, A) de la ligne de grille (30a).

10. Structure formant grille (28) selon la revendication 9, **caractérisée en ce que** le minimum du profil de la première probabilité (p_{ϕ1}) et/ou le minimum du profil de la deuxième probabilité (p_{ϕ2}) par rapport au centre (M2, M1) de la deuxième ou de la première portion (B, A) de la ligne de grille (30a) sont décalées, en rapprochement ou en éloignement, de l'autre portion respective (A, B) de la ligne de grille (30a) .

11. Structure formant grille (28) selon l'une des revendications 7 à 10, **caractérisée en ce que** le profil de la première probabilité (p_{ϕ1}) et/ou le profil de la deuxième probabilité (p_{ϕ2}) ont chacun un flanc (34a) qui est linéaire, sinusoïdal ou exponentiellement décroissant.

12. Structure formant grille (28) selon l'une des revendications 1 à 11, **caractérisée en ce que** les segments (24, 36) d'au moins deux lignes de grille adjacentes (30a, 30b) ont des positions (40, 42) qui sont décalées l'une de l'autre suivant une extension longitudinale des lignes de grille (30a, 30b) et **en ce que** le décalage de ces positions (40, 42) suivant l'extension longitudinale des lignes de grille (30a, 30b) est choisi aléatoirement.

13. Structure formant grille (28) selon l'une des revendications 1 à 12, **caractérisée en ce que** les segments (24, 26) du premier et du deuxième groupe sont conçus chacun en forme de parallélogramme, **en ce que** de petits côtés (44a à 44f) des segments (24, 26) sont chacun parallèles au premier axe de coordonnées (O1) du système de coordonnées de référence (11), et **en ce que** les segments (24, 26) du premier et du deuxième groupe présentent chacun la même étendue (Δy) suivant un deuxième axe de coordonnées (O1), s'étendant orthogonalement au premier axe de coordonnées (O1), du système de coordonnées de référence (11).

14. Structure formant grille (28) selon l'une des revendications 1 à 13, **caractérisée en ce que** les segments (24, 26 ; 36) d'approximation des lignes de grille (30) sont chacun des zones d'éclairement générées par projection cellulaire sur une surface de substrat (25) à l'aide de différents réticules (22) sélectionnables individuellement.
